# EUROPEAN PATENT APPLICATION

(11) **EP 1 646 077 A1**
(43) Date of publication of application: **12.04.2006**
(21) Application number: 04723660.9
(22) Date of filing: 26.03.2004
(51) Int. Cl.: H01L 21/203

(54) **NITRIDE SEMICONDUCTOR ELEMENT AND METHOD FOR MANUFACTURING THEREOF**

(30) Priority: 15.07.2003 JP 2003274964
(71) Applicant: KANAGAWA ACADEMY OF SCIENCE AND TECHNOLOGY, Kawasaki-shi, Kanagawa-ken 213-0012 (JP)
(72) Inventor: FUJIOKA, Hiroshi, Bunkyo-ku Tokyo 112-0002 (JP); OSHIMA, Masaharu, Tokyo 113-0021 (JP)
(74) Representative: Turner, James Arthur
(86) International application number: PCT/IB2004/000916
(87) International publication number: WO 2005/006420

(57) **Abstract**

Disclosed is a method for the preparation of a nitride semiconductor device having a nitride semiconductor layer composed of InN on which a high quality layer of a semiconductor of a nitride of a group III element typified by InN or GaN is grown as traversing dislocation or an interfacing layer is suppressed from being generated. The method includes a vapor depositing step of vapor depositing InN on the (111) plane of a yttria stabilized zirconia substrate (12) for forming the nitride semiconductor layer oriented with c-axis of an InN crystal of the hexagonal system substantially vertical with respect to the (111) plane of the substrate (12).

## Description

### Technical Field

This invention relates to a nitride semiconductor device, having a layer of a nitride semiconductor, comprised of InN or ZnO, a method for the preparation thereof, a semiconductor substrate on which to form the nitride semiconductor layer by vapor deposition, and a method for the preparation thereof.

The present application claims priority rights based on the JP Patent Application 2003-274964, filed in Japan on July 15, 2003, and which is to be incorporated in its entirety by reference herein.

### Background Art

In general, a semiconductor of a nitride of the group III element, typified by InN or GaN, may be changed significantly in its forbidden bandwidth, while a hetero structure may readily be prepared from it. Hence, the nitride semiconductor is stirring up notice as a constituent material of a light emitting device or a communication device, radiating light ranging from the infrared range to visible range and further to the ultraviolet range.

In particular, InN has recently been reported to possess the forbidden bandwidth of 1.0 eV or less, and the wavelength of radiated light may be set over the entire visible wavelength range. Hence, InN is highly efficacious for use as a display device. Also, the application of InN for a high frequency device exploiting its high electron mobility, in particular for a solar battery is felt to be promising. On the other hand, GaN is felt to be promising for use not only for a blue light emitting diode (LED) but also for a GaN based field effect transistor.

The nitride semiconductor is epitaxially grown on a sapphire substrate by mainly the MOCVD (Metal Organic Chemical Vapor Deposition)

However, there persists significant lattice misregistration between the nitride semiconductor and the sapphire substrate. For this reason, larger numbers of misfit dislocations are produced, based on the stress applied to the crystal lattice of the nitride semiconductor at the time of the epitaxial growth, as a result of which traversing dislocation through the nitride semiconductor layer is produced. Consequently, a crystal of high quality cannot be obtained and hence the device to be produced using the crystal is lowered in its entirety.

In particular, a strong demand for removing the above problem has been raised in connection with InN, as a material felt to be highly propitious as a structural material for a variety of devices, in consideration that there lacks up to now a substrate, other than an InN substrate, which is chemically stable and which also is free from lattice misregistration.

As for GaN, it has so far been known that use of a ZnO substrate may enable the lattice misregistration to be reduced. However, GaN suffers a problem that, since GaN and ZnO are reacted vigorously with each other, an interfacing layer is generated on a hetero interface, such that a high-quality GaN crystal cannot be obtained (for example, see Non-Patent Publication 2). There are also occasions where SiC having low reactivity to GaN is used as a material for a substrate on which to grow GaN. However, the SiC substrate, while allowing the epitaxial growth of a high-quality GaN crystal, is expensive, as a substrate, and may be formed only to a small area, so that it may not satisfy the demand for mass production.

### Disclosure of the Invention

In view of the above-depicted status of the art, it is an object of the present invention to provide a nitride semiconductor device, including a layer of a semiconductor of a nitride of an element of the group III, such as InN or GaN, grown to high quality as the traversing dislocation or the interfacing layer is suppressed from being produced, a method for the preparation of the nitride semiconductor device, a semiconductor substrate on which to form the nitride semiconductor layer by vapor deposition, and a method for the preparation of the semiconductor substrate.

For accomplishing the above object, the present invention provides a nitride semiconductor device comprising a substrate of yttria stabilized zirconia, referred to below as YSZ, and a nitride semiconductor layer including an InN crystal of the hexagonal system, with the InN crystal being oriented with the c-axis thereof approximately vertical with respect to the (111) plane of the YSZ substrate.

For accomplishing the above object, the present invention also provides a nitride semiconductor device comprising a ZnO substrate, and a nitride semiconductor layer including a GaN crystal of the hexagonal system, in which the GaN crystal is oriented with the c-axis thereof approximately vertical with respect to the (000-1) plane or the (0001) plane of the ZnO substrate.

For accomplishing the above object, the present invention also provides a nitride semiconductor device comprising a ZnO substrate, and a nitride semiconductor layer including an InₓGa₁₋ₓN (0 ≤ x ≤ 0.4) crystal of the hexagonal system, in which the InₓGa₁₋ₓN crystal is oriented with the c-axis thereof approximately vertical with respect to the (000-1) plane or the (0001) plane of the ZnO substrate.

For accomplishing the above object, the present invention also provides a method for the preparation of a nitride semiconductor device having a nitride semiconductor layer formed of InN, in which the method comprises a vapor depositing step of vapor depositing the InN on the (111) plane of a substrate of yttria stabilized zirconia, referred to below as YSZ.

For accomplishing the above object, the present invention also provides a method for the preparation of a nitride semiconductor device having a nitride semiconductor layer formed of GaN, in which the method comprises a vapor depositing step of vapor depositing InN on the (000-1) plane or the (0001) plane of a ZnO substrate at a temperature not higher than 510ºC.

For accomplishing the above object, the present invention also provides a method for the preparation of a nitride semiconductor device having a nitride semiconductor layer formed of InₓGa₁₋ₓN (0 ≤ x ≤ 0.4), in which the method comprises a vapor depositing step of vapor depositing the InₓGa₁₋ₓN on the (000-1) plane or the (0001) plane of a ZnO substrate at a temperature not higher than 510ºC.

For accomplishing the above object, the present invention also provides a semiconductor substrate comprising a yttria stabilized zirconia on the (111) plane of which an atomic step has been formed.

For accomplishing the above object, the present invention also provides a semiconductor substrate comprising a ZnO substrate on the (000-1) plane or the (0001) plane of which an atomic step has been formed.

For accomplishing the above object, the present invention also provides a method for the preparation of a nitride semiconductor substrate comprising a step of heating a substrate of yttria stabilized zirconia having a (111) plane crystal orientation at a temperature not lower than 800ºC.

For accomplishing the above object, the present invention also provides a method for the preparation of a nitride semiconductor substrate comprising a step of encircling a ZnO substrate having a (000-1) plane or the (0001) plane crystal orientation with sintered ZnO and heating the substrate in this state at a temperature not lower than 800ºC.

For accomplishing the above object, the present invention also provides a method for the preparation of a nitride semiconductor substrate comprising a step of encircling a ZnO substrate having a (000-1) plane or the (0001) plane crystal orientation with a Zn -containing material and heating the substrate in this state at a temperature not lower than 800ºC.

### Brief Description of the Drawings

Fig.1 shows a nitride semiconductor device employing InN for a nitride semiconductor layer.
Figs.2A and 2B illustrate atomic arrangement in a (111) plane of a YSZ substrate.
Figs.3A and 3B illustrate atomic arrangement of InN forming the nitride semiconductor layer.
Fig.4 shows the results of observation with an atomic force microscope of the (111) plane of a YSZ substrate 12, prepared on heating at 1250ºC for two hours.
Fig.5 illustrates the configuration of a PLD device.
Fig.6 shows a RHEED image of an InN crystal with respect to the (111) plane of the YSZ substrate.
Fig.7 shows the results of observation with an atomic force microscope of a nitride semiconductor device prepared.
Figs.8A and 8B show the results of X-ray diffractiometry carried out for a nitride semiconductor layer.
Figs.9A and 9B show the results of observation by TEM of the YSZ substrate and the nitride semiconductor layer.
Fig.10 shows a nitride semiconductor device employing GaN for a nitride semiconductor layer.
Fig. 11 illustrates a case where a mechanically polished ZnO substrate is heated as it is encircled by ZnO sintered pieces arranged in a box shape.
Figs.12A and 12B show the results of observation with an atomic force microscope of the (0001) plane of a heated ZnO substrate 52.
Fig. 13 shows the thickness of an interfacing layer formed on a hetero interface of GaN/ZnO, as plotted against the growth temperature of a GaN crystal.
Figs.14A and 14B show the results of observation of a RHEED image of GaN with respect to the (0001) plane or the (000-1) plane of the ZnO substrate 52.
Fig. 15 shows the profile of reflection intensity as obtained on oblique incidence of X-rays to a nitride semiconductor device 51 based on the GIXR method.
Fig.16 shows the results of RHEED oscillations of In_{0.2}Ga_{0.8}N, layered on the ZnO substrate 52.

### Best Mode for Carrying out the Invention

Referring to the drawings, preferred embodiments of the present invention will be explained in detail. The present invention is applied to a nitride semiconductor device having a layer of a semiconductor of a nitride of an element of the group III, typified by InN and GaN.

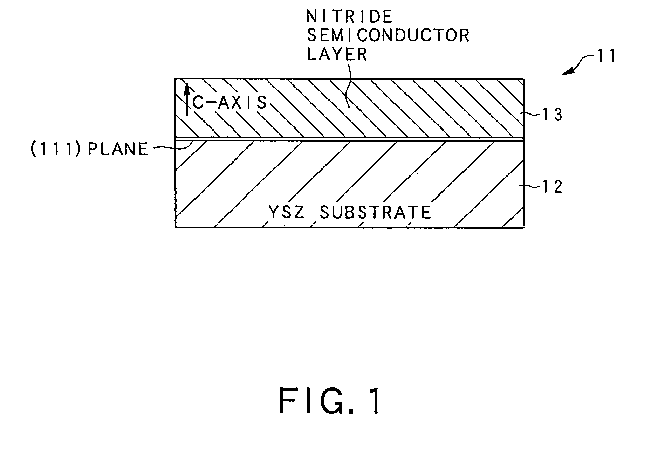

Fig.1 shows a nitride semiconductor device 11 employing InN for this nitride semiconductor layer. This nitride semiconductor device 11 includes a substrate of yttria stabilized zirconia (YSZ) 12, and a nitride semiconductor layer 13, with an InN crystal of the hexagonal system oriented with its c-axis substantially vertical with respect to the (111) plane of the substrate.

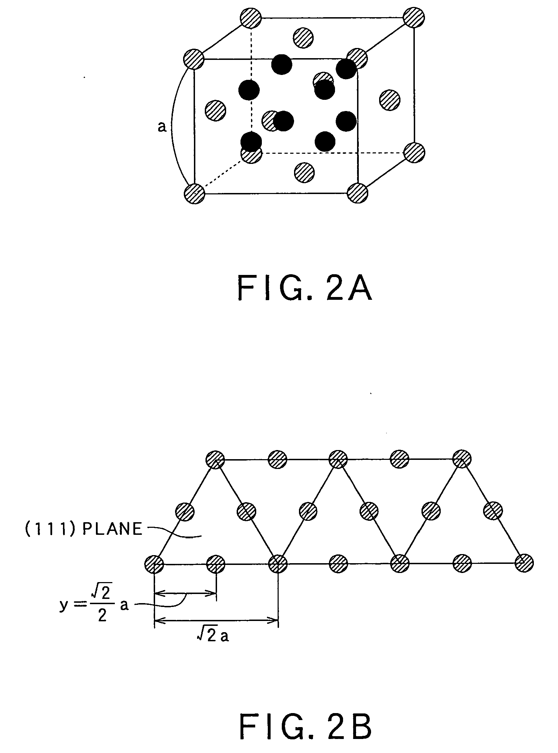

The YSZ of the YSZ substrate 12 is a stabilized zirconia of the cubic system, obtained on doping ZrO₂ of a fluorite structure, shown for example in Fig.2A, with Y₂O₃, in which Y atoms are partially substituted for Zr atoms. When the YSZ, having the above structure, is expressed as (ZrO₂)₁₋ₓ(Y₂O₃)ₓ, the lattice constant a is 5.14 Å, for a stoichiometric value x = 0.08 or thereabouts.

The YSZ substrate 12, having the above crystallographic structure, is prepared so that its (111) plane will become the substrate surface. Fig.2B shows the (111) plane of the YSZ substrate, having the above crystallographic structure, from the < 111 > direction. Each Zr atom (Y atom) on the (111) plane of a unit lattice of the YSZ, shown in Fig.2B, is located on a regular triangle each side of which is √2a long. The distance y between neighboring Zr atoms (Y atoms), out of the Zr atoms (Y atoms) located on the regular triangle, is expressed as √2a/2. If the lattice constant a is 5.14 Å, as described above, the distance y is 3.63 Å.

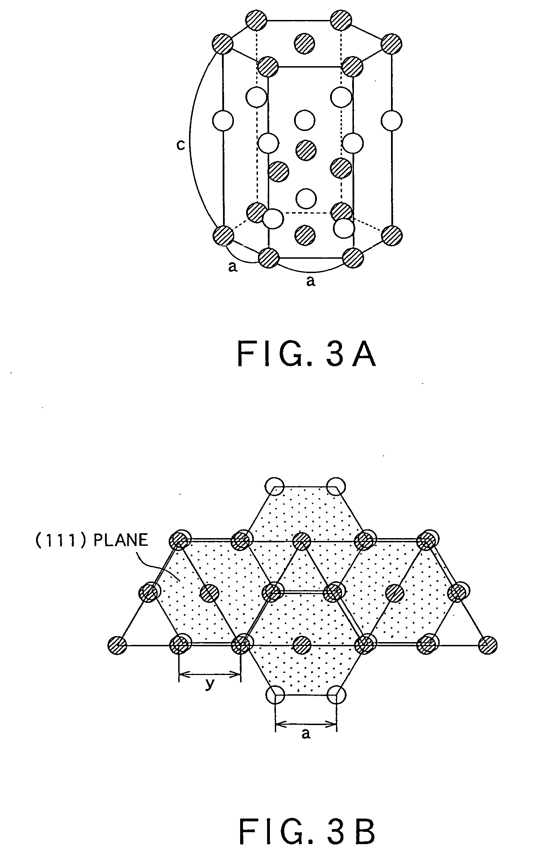

With InN, forming the nitride semiconductor layer 13, layered on the YSZ substrate 12, In atoms and N atoms are arrayed in a unit lattice formed by a mineral wurzitic structure of the hexagonal system, shown for example in Fig.3A. The symmetry is threefold with an angular interval of 120º. Six In atoms form the lowermost layer, and three N atoms are packed as an upper layer with respect to the lowermost layer. As an upper layer with respect to the N atoms, three In atoms are packed alternately. The lattice constants of InN are such that a = 3.55 Å and c = 5.76 Å.

In case InN, having the above-described crystallographic structure, is formed at an angle shown in Fig.3B with respect to the (111) plane of the YSZ substrate, the In atom locations are in register with the locations of Zr atoms (Y atoms), such as to improve lattice registration. The lattice misregistration of the hexagonal InN, with the lattice constant a (= 3.55 Å), with respect to the distance y (= 3.63 Å) between neighboring Zr atoms (Y atoms), is approximately 2.34 %, which is a low enough value even as compared to lattice misregistration of semiconductors of nitrides of the other group III elements with respect to the (111) plane of the YSZ substrate 12 (14.5 % for AIN and 12.3% for GaN).

The method for the preparation of the nitride semiconductor device 11, employing InN as the nitride semiconductor layer 13, will now be explained.

The YSZ substrate 12, sliced so that the substrate surface will become the (111) plane, is mechanically polished, using e.g. a diamond slurry. For this mechanical polishing, the particle size of the diamond slurry used is progressively reduced until ultimately the substrate is polished to a mirror surface using a diamond slurry with a particle size of approximately 0.5µm. The polished surface may be planarized to an rms value of surface roughness not larger than 10 Å or less by further polishing the surface using colloidal silica.

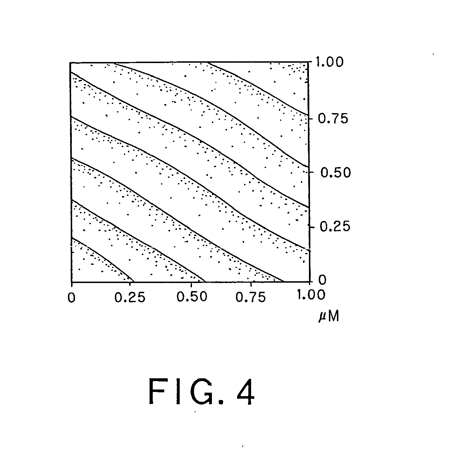

The YSZ substrate 12, mechanically polished in this manner, is then heated by placing it in an air atmosphere in a heated oven which is controlled to a temperature 800ºC or higher. Fig.4 shows the results of observation by an atomic power microscope of the (111) plane of the YSZ substrate 12, prepared on heating at 1250ºC for two hours. This Fig.4 shows that smooth linear atomic steps are regularly formed on the (111) plane of the YSZ substrate 12. This atomic step is formed by a crystallographic plane re-arranged by heat treatment, and exhibits the same smooth crystallographic orientation. This atomic step has a height approximately 0.3 nm which is equivalent to the interval between (111) planes in the YSZ substrate 12, in other words, to the interatomic distance of Zr atoms.

That is, the YSZ substrate 12, carrying the atomic steps, may be prepared by heat-treating the YSZ substrate 12, based on the above conditions. The height of the so formed atomic step corresponds to the interatomic distance of the Zr atoms, as described above, and represents crest and recesses of the smallest order of magnitude that may be formed on the YSZ substrate 12. The fact that these atomic steps may be observed on the YSZ substrate 12 means that the substrate surface may be finished to the most planar state without there being present crests or recesses of the order of magnitude larger than the height of the interatomic distance, and that an optimum InN thin film may be formed. Since these atomic step may turn out to be nuclei in the epitaxial growth of InN, it may likewise be possible to optimize the film-forming environment.

Meanwhile, the above atomic step may be prepared if the temperature for heating processing exceeds 800ºC. If lower heating temperatures are used, a correspondingly longer heating time is required.

Then, InN is vapor deposited on the (111) surface of the YSZ substrate 12, in accordance with the physical vapor deposition method. In the embodiment, now explained, this vapor deposition is executed in accordance with a pulse laser deposition (PLD) method.

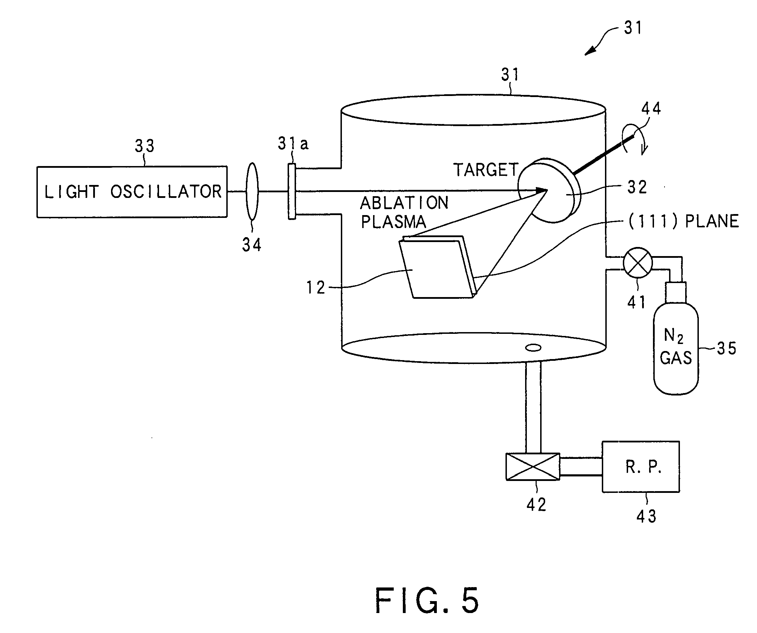

With this PLD method, a nitride semiconductor layer 13 is deposited on the YSZ substrate 12, using a PLD device 30 shown for example in Fig.5. This PLD device 30 includes a YSZ substrate 12 and a target 32 arranged within a chamber 31. The PLD device also includes a light oscillator 33, arranged outside the chamber 31 for facing the target 32, and a lens 34 for controlling the spot diameter of a pulsed laser light beam, oscillated by the light oscillator 33, and a gas supply unit 35 for injecting a nitrogen gas into the chamber 31.

The chamber 31 is provided for equalizing e.g. the concentration of a nitrogen gas to be charged. There is provided an adjustment valve 41 for controlling the gas concentration in the chamber 31 for controlling the state of adsorption to the YSZ substrate 12 as the relationship between the gas molecules and the wavelength of the pulsed laser light beam is taken into account. Outside the chamber 31, there is provided a pressure valve 42 for controlling the internal pressure, such that the pressure within the chamber is controlled by a rotary pump 43 to be 5 × 10⁻⁵ to 1 × 10⁻² Torr in a nitrogen atmosphere, as the process of the PLD method of forming a film under a reduced pressure is taken into consideration. There. is further provided a window 31 a in an area of a surface of the chamber 31 facing the target 32, and a pulsed laser light beam from the light oscillator 33 is incident via window 31 a.

The light oscillator 33 oscillates, as the pulsed laser light beam, a KrF excimer laser, having a pulse frequency of 5 to 15 Hz, a laser power of 3J/cm² and a wavelength of 248 nm. The oscillated pulsed laser light beam is incident on the surface of the target 32, provided within the chamber 31, via window 31a, at an angle of approximately 30º, as the spot of the pulsed laser light beam is adjusted by a lens 34 so that its focus will be in the vicinity of the target 32.

The target 32 is formed e.g. of metal In (purity: 99.999 to 99.9999%), and is arranged substantially parallel to the (111) plane of the YSZ substrate 12. The target 32, run in rotation by a rotating shaft 44, is intermittently irradiated with the pulsed laser light. This abruptly raises the temperature on the surface of the target 32 to generate ablation plasma. The In atoms, contained in this ablation plasma, are progressively changed in their states, and moved onto the YSZ substrate 12, as the In ions undergo collision reactions with the nitrogen gas in the nitrogen atmosphere. On arrival at the YSZ substrate 12, the particles, containing the In ions, are directly diffused onto the (111) plane on the YSZ substrate 12, to form a thin film in the state of most stable lattice registration. The result is that the nitride semiconductor device 11, having the above configuration, is prepared.

It should be noted that the nitride semiconductor device 11 may be formed not only by the above-described PLD method, but also by other suitable physical vapor deposition (PVD) methods, such as a molecular beam epitaxial (MBE) method or a sputtering method. However, as long as the growth of InN is concerned, it is more preferred to use the PLD method than the usual MBE method. In actuality, the half-value width of an X-ray lock-in curve of the 20-24 plane by the PVD method is 0.35º, which is significantly smaller than 0.60º for the MBE method. This is presumably ascribable to the fact that, with the PLD method, the group III elements, such as In, incident on the substrate, possess a marked kinetic energy and hence is extremely mobile on the substrate surface.

The nitride semiconductor device 11 may be prepared not only by the PVD method but also by a chemical vapor deposition (CVD) method exploiting a MOCVD method, for example.

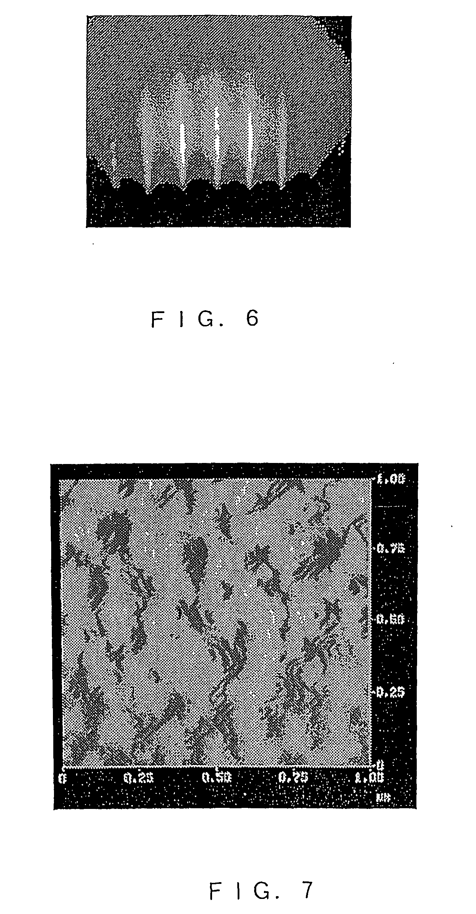

Meanwhile, in the course of the vapor deposition of InN, which is based on this PLD method, status changes may be measured in real-time based on the reflection high energy electron diffraction (RHEED) method. Fig.6 shows the results of observation of a RHEED image of the InN crystal, with respect to the (111) plane of the YSZ substrate 12, based on this RFEED method. This Fig.6 shows that a sharp streaked pattern has been obtained for the InN crystal. It is because lattice misregistration of InN with respect to the (111) plane of the YSZ substrate 12 is as small as 2.34%. That is, from this streaked pattern, it may be estimated that a planar high-quality crystal has been grown, such that expectations may be made that there will be formed a nitride semiconductor layer 13 of a high-quality InN thin film.

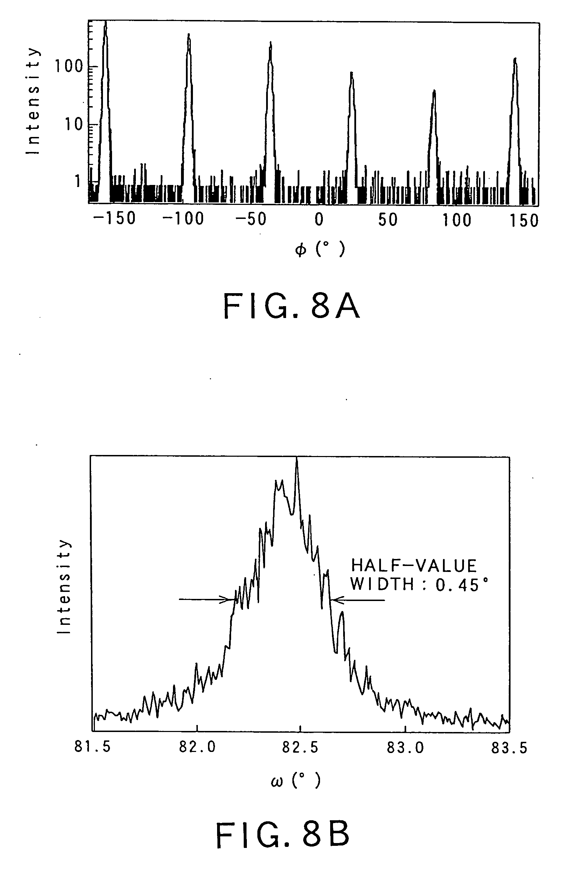

Fig.7 shows the results of observation by the atomic force microscope of the nitride semiconductor device 11 prepared in accordance with the above-described method. This Fig.7 shows particles in the form of hexagonal pillars deposited everywhere on the YSZ substrate 12. It is because the hexagonal InN crystal is oriented with its c-axes substantially vertical with respect to the (111) plane of the YSZ substrate 12.

Fig.8A shows the results of X-ray diffractiometry (XRD) of the nitride semiconductor layer 13 of the nitride semiconductor device 11 prepared. In the XRD spectrum, shown in Fig. 8A, there occur peaks substantially at an interval of 60º, thus testifying to the fact that hexagonal InN crystal is oriented with the c-axis of the hexagonal crystal substantially vertical with respect to the (111) plane.

Fig.8B shows a peak appearing in the vicinity of 82º in the above XRD spectrum to an enlarged scale. This enlarged view of Fig.8B indicates that the half-value width of the peak is 0.45º such that there has been obtained a high-quality thin InN film exhibiting high crystallinity.

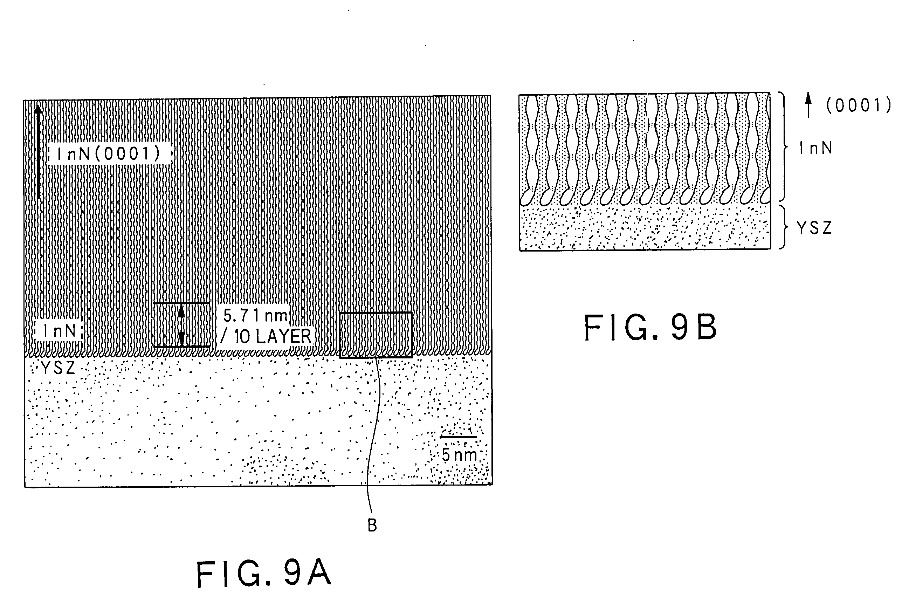

Fig.9A shows the cross-section of the YSZ substrate 12 and the nitride semiconductor layer 13 of the nitride semiconductor device 11, as observed with a TEM (Transmission electron Microscope). The direction indicated by an arrow A in Fig.9A denotes the <0001> direction (c-axis direction) of InN constituting the nitride semiconductor layer 13 deposited on the YSZ substrate 12. The image observed with the TEM also testifies to the formation of the high-quality InN.

In this image, as observed with the TEM, an area B is shown enlarged in Fig.9B. It may be seen from this enlarged view that InN of the hexagonal system is oriented in the <0001> direction. In particular, an acute hetero interface has been formed between the YSZ substrate 12 and the nitride semiconductor layer 13. It may also be seen that misfit dislocation has been produced at a rate of one for 47 deposited InN crystals. This misfit dislocation has been produced as a result of lattice misregistration of InN with respect to the (111) plane of YSZ. With the nitride semiconductor device 11, embodying the present invention, this lattice misregistration may be suppressed to an extremely low level of 2.34%, so that the chance of occurrence of the misfit dislocation may be lower than with the conventional method.

Since this misfit dislocation may be suppressed significantly, and hence the traversing dislocation through the nitride semiconductor layer 13 may be suppressed, it becomes possible to produce a high-quality InN crystal, while it becomes also possible to improve significantly the quality of the nitride semiconductor device 11, including the nitride semiconductor layer 13, formed by the high-quality InN crystal, in its entirety.

In particular, the forbidden bandwidth of InN has recently been reported to be 1.0 eV or less, such that the wavelength of radiated light may be set to cover the entire visible range. Hence, the nitride semiconductor device 11, composed of the InN, as the nitride semiconductor layer 13, may be put to a large variety of applications, such as light emitting devices, communication devices or solar batteries. In particular, since the nitride semiconductor device 11 uses the YSZ substrate 12, chemically stable and exhibiting lattice registration with respect to InN, it becomes possible to improve the performance of various devices employing the nitride semiconductor device.

In the above explanation of the method for preparation of the nitride semiconductor device 11, the YSZ substrate 12, having atomic steps formed thereon in advance, is used. However, it is also possible to form the InN film even with the use of the YSZ substrate not having atomic steps.

The stoichiometric value x of Y₂O₃, to be doped in ZrO₂, is not limited to x = 0.08, and may be any suitable value depending on the usage and application. Since the lattice constant of YSZ may be controlled by controlling the stoichiometric value x, it becomes possible to reduce the misfit dislocation further by further reducing the aforementioned lattice misregistration.

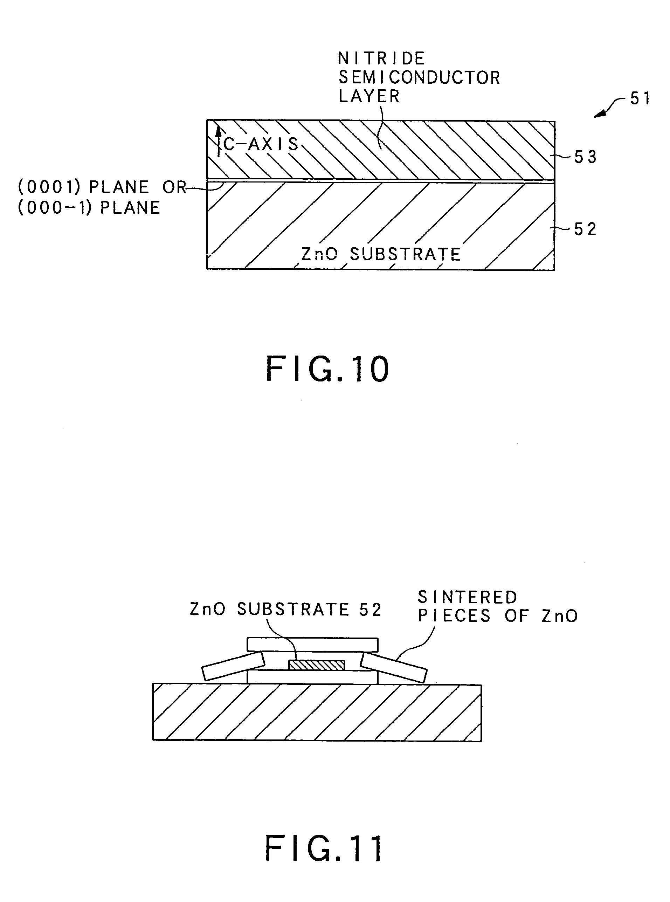

A nitride semiconductor device 51, employing GaN in the nitride semiconductor layer, will now be explained in detail. The nitride semiconductor device 51 includes a nitride semiconductor layer 53, oriented with the c-axis of hexagonal GaN approximately vertical with respect to the (0001) plane or the (000-1) plane of a ZnO substrate 52, composed of ZnO, as shown in Fig. 10.

ZnO, forming the ZnO substrate 52, is of the wurtzitic crystallographic structure, shown in Fig.3A, and has a lattice constant a = 3.252 Å, a forbidden bandwidth of 3.2 eV and an exciton binding energy of 60 meV.

GaN, forming the nitride semiconductor layer 53, layered on the ZnO substrate 52, also is of the wurtzitic crystallographic structure, and has a lattice constant a = 3.189 Å, a forbidden bandwidth of 3.4 eV and an exciton binding energy of 21 meV.

Since ZnO and GaN, having such crystallographic structures, are approximately equal in the lattice constant, the lattice misregistration may be reduced to as small a value as possible.

The method for the preparation of the nitride semiconductor device 11, composed of GaN, will now be explained.

Initially, the ZnO substrate 52, sliced so that the substrate surface will be the (0001) plane or the (000-1) plane, is mechanically polished, using e.g. the diamond slurry or colloidal silica. The substrate surface may be planarized up to an rms value of surface roughness of 10 Å or less.

The mechanically polished ZnO substrate 52 is then heated, in a heated oven controlled to a temperature not lower than 800ºC, as it is encircled by plural sintered ZnO pieces, arranged in a box shape. It is sufficient that the ZnO substrate 52 is surrounded by the sintered ZnO pieces, while it is not indispensable that the ZnO substrate 52 is surrounded in its entirety by the surrounding sintered pieces. The ZnO substrate 52 may also be placed in a crucible formed of, for example, sintered ZnO. The ZnO substrate 52 may also be put in a box prepared from plural sintered ZnO pieces.

Above all, since Zn has a higher vapor pressure, there persists a problem that, if the ZnO substrate 52, composed of Zn, is heated, the substrate tends to be decomposed. By heating the ZnO substrate 52, encircled by the ZnO pieces, as shown in Fig. 11, the state as if the vapor pressure of ZnO is applied to the ZnO substrate 52, being heated, is established, and hence it becomes possible to prevent the decomposition of the ZnO substrate 52.

More specifically, when the ZnO substrate is not encircled by the sintered ZnO pieces, Zn is efficiently removed from the ZnO substrate 52, in accordance with the reaction formula 2ZnO = 2Zn + O₂, because of the relatively high vapor pressure of Zn. In case the ZnO substrate 52 is encircled by the sintered ZnO pieces, Zn of these sintered ZnO pieces is moved into the vapor phase around the ZnO substrate 52, as a result of which the Zn concentration in the vapor phase is raised. Since the fugacity of Zn, that is, the ability of Zn escaping from the ZnO substrate 52 into the vapor phase, may be lowered, it becomes possible to suppress decomposition of the ZnO substrate 52 per se.

It is noted that, for suppressing Zn from escaping from the ZnO substrate 52 into the vapor phase, the ZnO substrate 52 may be encircled by a Zn-containing material, instead of by the sintered ZnO pieces. The Zn-containing material may be exemplified by, for example, a ZnO single crystal or a Zn plate. By so doing, it becomes similarly possible to suppress the decomposition of the ZnO substrate 52 per se.

The above-described heating method may be applied not only to the case of heating the ZnO substrate 52, but also to a case of heating a substrate material, composed of the following compounds, as the substrate material is encircled by a sintered product formed of the same compound as that of the substrate material.

For example, a LiNbO₃ substrate may be encircled by sintered pieces of LiNbO₃, as described above, to suppress decomposition of Li. Since a terrace planar to the atomic level, partitioned by steps of an atomic layer, each with a height of 2 to 3 Å, is formed on the surface of the LiNbO₃ substrate, heated as described above, the GaN crystals, grown thereon, may be improved in cristallinity significantly.

The LiNbO₃ substrate may be surrounded not by the sintered pieces of LiNbO₃, but by a Li-containing material. By heating the LiNbO₃ substrate, thus encircled by the Li-containing material, it is possible to suppress the decomposition of the LiNbO₃ substrate.

A LiTaO₃ substrate may be encircled by LiTaO₃, as described above, to suppress decomposition of Li. By heating the LiTaO₃ substrate, thus encircled by the Li-containing material, it is possible to suppress the decomposition of the LiTaO₃ substrate. As for a SrTiO₃ substrate, it may be encircled by sintered pieces of SrTiO₃, as described above, to suppress decomposition of Sr. In such case, decomposition of the SrTiO₃ substrate may be suppressed by encircling the substrate with the Sr containing material, followed by heating. As for the LiGaO₂ substrate, it may be encircled with sintered LiGaO₂ to suppress the decomposition of Li. In such case, decomposition of the LiGaO₂ substrate may be suppressed by encircling the substrate with the Li containing material followed by heating. As for the MgO substrate, it may be encircled with sintered MgO to suppress the decomposition of Mg. In such case, decomposition of the MgO substrate may be suppressed by encircling the substrate with the Mg containing material followed by heating. As for the LiAlO₂ substrate, it may be encircled with sintered LiAlO₂ to suppress the decomposition of Li. In such case, decomposition of the LiAlO₂ substrate may be suppressed by encircling the substrate with the Li containing material the sintered LaSrAlTaO₃ to suppress the decomposition of La. In such case, decomposition of the LaSrAlTaO₃ substrate may be suppressed by encircling the substrate with the La containing material followed by heating.

The above-described method of processing for heating may be applied for suppressing decomposition of elements exemplified by K, Ca, Na, Zn, Te, Mg, Sr, Yb, Li, Eu, Ca, Hg and Bi.

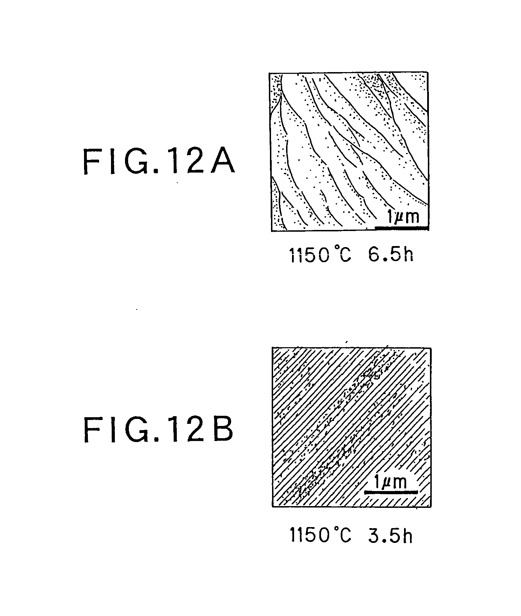

Fig.12A shows the (0001) plane of the ZnO substrate 52, heated at 1150ºC for 6.5 hours, as observed with an atomic force microscope. It is seen from Fig.12A that curved atomic steps have been formed on the (0001) plane of the ZnO substrate 52. Fig.12B shows the (000-1) plane of the ZnO substrate 52, heated at 1150ºC for 3.5 hours, as observed with an atomic force microscope. It is seen from Fig.12B that smooth linear atomic steps have been formed in a regular pattern on the (000-1) plane of the ZnO substrate 52. Meanwhile, the height of each atomic step, as measured using an atomic force microscope, was found to be approximately 0.5 nm.

That is, by heating the ZnO substrate 52, under the aforementioned conditions, it becomes possible to form the atomic steps on the ZnO substrate 52, which substrate may be used as a substrate for crystal growth thereon. The fact that these atomic steps may be observed indicates that the substrate surface may be finished to the most planar state to enable an optimum GaN thin film to be formed thereon. In addition, since these atomic steps may turn out to be the nuclei for epitaxial growth of GaN, the film-forming environment may be improved further.

Then, GaN is deposited on the (0001) plane or the (000-1) plane of the ZnO substrate 52, as the substrate is heated, in accordance with the above-described PLD method. At this time, the pressure in the chamber 31 in the PLD device 30 is controlled to be 1 × 10⁻¹ Torr in a nitrogen atmosphere. The light oscillator 33 oscillates a KrF excimer laser, with the laser power of 3J/ cm², as pulsed laser light. The target 32 is formed of metal Ga, with a purity of 99.99 %, and the ZnO substrate 52 is arranged so that its (0001) plane or (000-1) plane of the heated ZnO substrate 52 will be substantially parallel to the surface of the target 32.

Ga atoms are contained in the ablation plasma generated on intermittent illumination of the pulsed laser light beam on this target 32. These Ga atoms are moved towards the ZnO substrate 52 as the Ga atoms are subjected to repeated collision reactions with nitrogen gas contained in the nitrogen atmosphere so as to change their states progressively. On reaching the ZnO substrate 52, the particles containing the Ga atoms are directly diffused on the (0001) plane or the (000-1) plane on the ZnO substrate 52 to form a thin film in the most stable state of lattice registration. As a result, the nitride semiconductor device 51, having the above structure, has now been formed.

Meanwhile, the nitride semiconductor device 51 may similarly be prepared by other suitable physical vapor deposition methods or chemical vapor deposition methods.

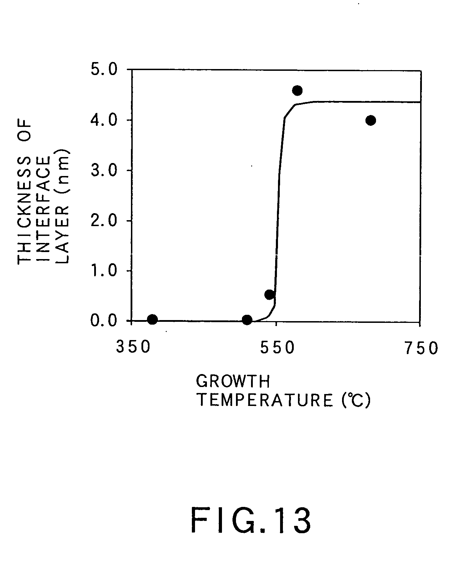

Fig.13 shows a thickness of an interfacing layer, formed on a GaN/ZnO hetero interface, against the growth temperature of the GaN crystal. As may be seen from Fig.13, the interfacing layer, formed on the hetero interface, is abruptly increased in thickness when the growth temperature exceeds about 550ºC. Thus, it may be seen that GaN and ZnO react abruptly when the growth temperature exceeds about 550ºC.

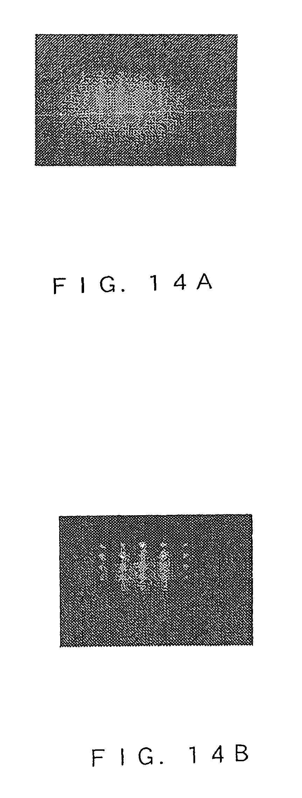

Figs.14A and 14B show a RHEED image of GaN with respect to the (0001) plane or the (000-1) plane of the ZnO substrate 52 in accordance with the RHEED method. Fig.14A shows that a sharp streaked pattern has been obtained for GaN in case the growth temperature is 510ºC, such that growth of a high quality crystal has been achieved. Conversely, Fig.14B shows that, in case the growth temperature is set to 680ºC, an interfacing layer is generated on the hetero interface, such that three-dimensional growth of GaN occurs, with the GaN crystal growth behavior evidently differing between the two cases.

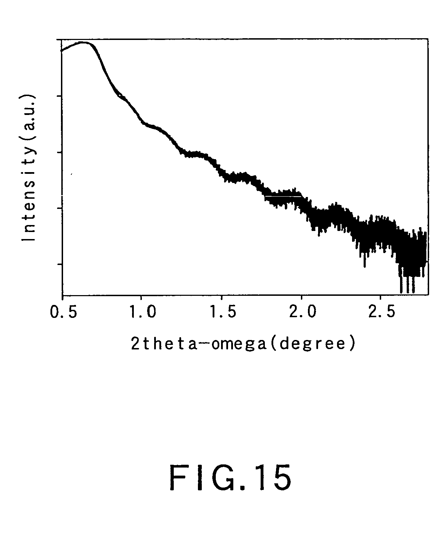

Fig.15 shows the results of analysis of the profile of reflection intensity as obtained on oblique incidence of X-rays to a nitride semiconductor device 51, prepared with the growth temperature of 510ºC, based on the GIXR (Grazing Incidence X-Ray Reflectivity) method. It is seen from this profile of the reflection intensity that, when the growth temperature is set to 510ºC, no interfacing layer has been formed on the hetero interface.

Thus, from the profile of GIXR and from the above RHEED image, it is shown that, in case the growth temperature is set to 510ºC or lower, the reaction of GaN and ZnO may be suppressed to suppress the generation of the interfacing layer.

Hence, in preparing the nitride semiconductor device 51 of the present invention, the growth temperature for GaN is controlled to be not higher than 510ºC. It becomes possible in this manner to create a steep interface, where there is present no interfacing layer, between the ZnO substrate 52 and the nitride semiconductor layer 53. In particular, since the ZnO substrate 52, heated as described above, has been planarized to a nanometric order, it becomes possible to form a steeper hetero interface. Thus, according to the present invention, the GaN crystal, obtained on vapor deposition, may be of higher quality, thus enabling the entire nitride semiconductor device 51 to be improved in quality.

Meanwhile, the growth temperature of GaN may be lowered to approximately the ambient temperature by taking advantage of ease of reaction of GaN with respect to ZnO. When the reaction is carried out at higher temperatures, the crystals may become defective, as a result of thermal shock resistance accompanying the post-reaction cooling, thus possibly lowering the quality of the resulting nitride semiconductor device 51. This generation of crystal defects may be suppressed by lowering the GaN growth temperature to ambient temperature.

In particular, GaN may be used, owing to its forbidden bandwidth, for a large variety of usages and application, such as GaN based field effect transistors, besides blue light emitting diodes (LEDs). With the nitride semiconductor device 51, obtained on growing the high-quality GaN crystal on the ZnO substrate 52, it is possible to improve the performance of the various devices representing the application of GaN.

In the above-described method for the preparation of the nitride semiconductor device 51, according to the present invention, the case of employing the ZnO substrate 52, having atomic steps formed thereon in advance, is taken as an example for explanation. However, the nitride semiconductor layer 53 may also be formed using a ZnO substrate not including the atomic steps.

The nitride semiconductor device 51, embodying the present invention, is not limited to the one described in the above-described embodiments. For example, part of the elements forming the nitride semiconductor layer 53 may be replaced by other suitable elements.

For example, InGaN, obtained on substituting the element In for part of the element Ga constituting the nitride semiconductor layer 53, may be layered on the ZnO substrate 52 planarized to the atomic level. Since InGaN is closer in lattice constants to ZnO than GaN, it is possible to obtain crystals of higher quality. By layering In_{0.2}Ga_{0.8}N, obtained on substituting the element In for 20% of the element Ga, on the ZnO substrate 52, the nitride semiconductor device 51 may be improved in quality more significantly.

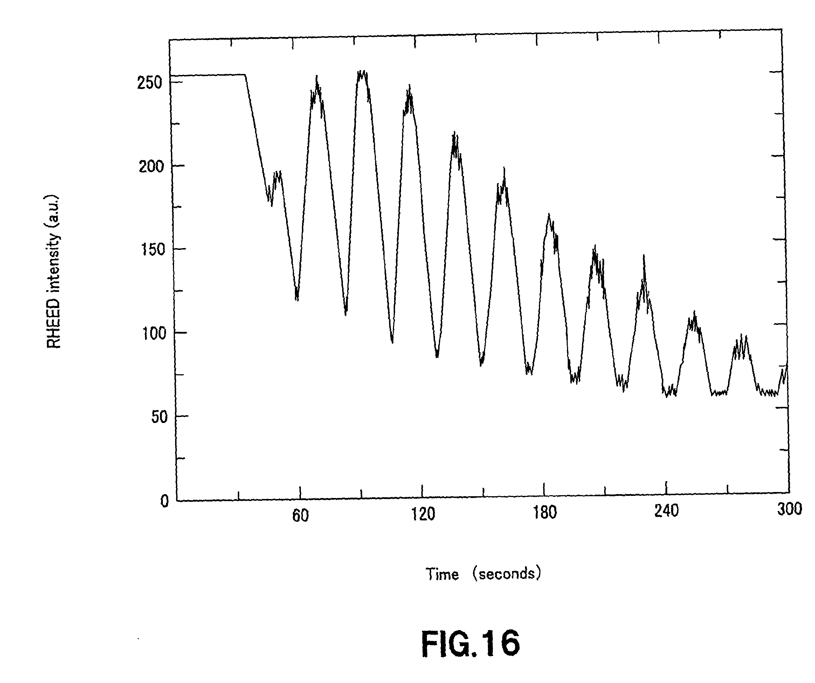

Fig. 16 shows the results of observation of the RHEED oscillations of In_{0.2}Ga_{0.8}N layered on the ZnO substrate 52. It may be seen from Fig. 16 that strong RHEED oscillations are observed from the initial stage of crystal growth, such that crystallinity has been improved appreciably. Meanwhile, it is of course possible to layer GaN further on In_{0.2}Ga_{0.8}N layered on this ZnO substrate 52.

It should be noted that the above-described favorable operation and efficacy may be obtained in case 0 ≤ x ≤ 0.4 in InGaN expressed as InₓGa₁₋ₓ N.

The present invention is not limited to the above embodiment, explained with reference to the drawings and, as will be apparent to those skilled in the art, a large variety of changes or substitution by equivalents may be attempted without departing from the scope of the invention as defined in the appended claims.

### Industrial Applicability

The nitride semiconductor device according to the present invention, described above, includes a nitride semiconductor layer, with the c-axis of InN of the hexagonal system substantially vertical with respect to the (111) plane of a substrate of yttria stabilized zirconia, referred to below sometimes as YSZ. Since this allows for suppression of lattice misregistration, it becomes possible to prohibit generation of misfit dislocations, and hence to suppress the dislocation traversing the nitride semiconductor layer.

The nitride semiconductor device according to the present invention, described above, includes a nitride semiconductor layer, with the c-axis of GaN of the hexagonal system substantially vertical with respect to the (000-1) plane or the (0001) plane of a ZnO substrate. That is, since no interfacing layer is formed on the hetero interface of the nitride semiconductor device, the nitride semiconductor device includes a nitride semiconductor layer composed of a high quality GaN crystal, and hence the various apparatus, employing the nitride semiconductor device, may be improved in performance.

The method for the preparation of the nitride semiconductor device according to the present invention is the method for the preparation of a nitride semiconductor device having a nitride semiconductor layer formed of InN, in which the method comprises the step of vapor-depositing InN on the (111) plane of the YSZ substrate. This enables a nitride semiconductor layer to be formed on the (111) plane of the YSZ substrate, in which the nitride semiconductor layer is formed by a high quality InN crystal suffering from lattice misregistration only to a lesser extent.

The method for the preparation of the nitride semiconductor device according to the present invention is the method for the preparation of a nitride semiconductor device having a nitride semiconductor layer formed of GaN, in which the method comprises the step of vapor-depositing the GaN at a temperature not higher than 510ºC on the (000-1) plane or on the (0001) plane of the ZnO substrate at a temperature not lower than 510ºC. This enables a steep interface, devoid of the interfacing layer, to be generated between the ZnO substrate and the nitride semiconductor layer to provide for growth of a high-quality GaN crystal.

A semiconductor substrate, embodying the present invention, includes an atomic step formed on the (111) plane of the yttrria stabilized zirconia substrate. In this manner, a high-quality thin InN film may be formed on the semiconductor substrate.

Another semiconductor substrate, embodying the present invention, includes an atomic step formed on the (000-1) plane or the (0001) plane of the Zn substrate. In this manner, a high-quality thin GaN film may be formed on the semiconductor substrate.

The method for the preparation of the semiconductor substrate according to the present invention also includes a step of heating a yttria stabilized zirconia substrate, having a crystal orientation in the (111) plane, at a temperature not lower than 800ºC. Thus, with the present method for the preparation of the semiconductor substrate, it becomes possible to form an atomic step on the (111) plane of the yttria stabilized zirconia substrate.

The method for the preparation of the semiconductor substrate according to the present invention further includes a step of encircling a ZnO substrate, having the crystal orientation in the (000-1) plane or the (0001) plane, with sintered ZnO pieces, and heating the substrate in this state at a temperature not lower than 800ºC. Thus, with the present method for the preparation of the semiconductor substrate, an atomic step may be formed on the (000-1) plane or the (0001) plane of the Zn substrate.

## Claims

1. A nitride semiconductor device comprising a substrate of yttria stabilized zirconia, referred to below as YSZ, and a nitride semiconductor layer including an InN crystal of the hexagonal system, said InN crystal being oriented with the c-axis thereof approximately vertical with respect to the (111) plane of said YSZ substrate.

2. The nitride semiconductor device according to claim 1 wherein an atomic step is formed on the (111) plane of said YSZ substrate.

3. A nitride semiconductor device comprising a ZnO substrate, and a nitride semiconductor layer including a GaN crystal of the hexagonal system, said GaN crystal being oriented with the c-axis thereof approximately vertical with respect to the (000-1) plane or the (0001) plane of said ZnO substrate.

4. The nitride semiconductor device according to claim 3 wherein an atomic step is formed on the (000-1) plane or on the (0001) plane of said ZnO substrate.

5. A nitride semiconductor device comprising a ZnO substrate, and a nitride semiconductor layer including an InₓGa₁₋ₓN (0 ≤ x ≤ 0.4) crystal of the hexagonal system, said InₓGa₁₋ₓN crystal being oriented with the c-axis thereof approximately vertical with respect to the (000-1) plane or the (0001) plane of said ZnO substrate.

6. A method for the preparation of a nitride semiconductor device having a nitride semiconductor layer formed of InN, comprising
a vapor depositing step of vapor depositing said InN on the (111) plane of a substrate of yttria stabilized zirconia, referred to below as YSZ.

7. The method for the preparation of a nitride semiconductor device according to claim 6 wherein, in said vapor deposition step, said InN is grown epitaxially in accordance with a physical vapor deposition (PVD) method or a chemical vapor deposition (CVD) method.

8. The method for the preparation of a nitride semiconductor device according to claim 6 further comprising
a step of forming an atomic step in advance on said (111) plane of said YSZ substrate;
said InN being vapor-deposited in said vapor depositing step on the YSZ substrate on which said atomic step has been formed.

9. The method for the preparation of a nitride semiconductor device according to claim 8 wherein the YSZ substrate having crystal orientation in the (111) plane is heated at a temperature not lower than 800ºC.

10. A method for the preparation of a nitride semiconductor device having a nitride semiconductor layer formed of GaN, comprising
a vapor depositing step of vapor depositing GaN on the (000-1) plane or the (0001) plane of a ZnO substrate at a temperature not higher than 510ºC.

11. The method for the preparation of a nitride semiconductor device according to claim 10 wherein, in said vapor deposition step, said GaN is grown epitaxially in accordance with a physical vapor deposition (PVD) method or a chemical vapor deposition (CVD) method.

12. The method for the preparation of a nitride semiconductor device according to claim 10 further comprising
a step of forming an atomic step in advance on said (000-1) plane or the (0001) plane of said ZnO substrate;
said GaN being vapor-deposited in said vapor depositing step on the ZnO substrate on which said atomic step has been formed.

13. The method for the preparation of a nitride semiconductor device according to claim 12 wherein, in said step forming step, the ZnO substrate, having crystal orientation in the (000-1) plane or in the (0001) plane, is encircled with sintered ZnO and heated in this state to a temperature not lower than 800ºC.

14. The method for the preparation of a nitride semiconductor device according to claim 12 wherein, in said step forming step, the ZnO substrate, having crystal orientation in the (000-1) plane or in the (0001) plane, is encircled with a Zn containing material and heated in this state to a temperature not lower than 800ºC.

15. The method for the preparation of a nitride semiconductor device according to claim 10 wherein, in said vapor deposition step, GaN is vapor-deposited at ambient temperature.

16. A method for the preparation of a nitride semiconductor device having a nitride semiconductor layer formed of InₓGa₁₋ₓN (0 ≤ x ≤ 0.4), comprising
a vapor depositing step of vapor depositing said InₓGa₁₋ₓN on the (000-1) plane or the (0001) plane of a ZnO substrate at a temperature not higher than 510ºC.

17. A semiconductor substrate comprising a yttria stabilized zirconia on the (111) plane of which an atomic step has been formed.

18. A semiconductor substrate comprising a ZnO substrate on the (000-1) plane or the (0001) plane of which an atomic step has been formed.

19. A method for the preparation of a nitride semiconductor substrate comprising a step of heating a substrate of yttria stabilized zirconia having crystal orientation in the (111) plane at a temperature not lower than 800ºC.

20. A method for the preparation of a nitride semiconductor substrate comprising a step of encircling a ZnO substrate having crystal orientation in the (000-1) plane or in the (0001) plane with sintered ZnO and heating the substrate in this state at a temperature not lower than 800ºC.

21. A method for the preparation of a nitride semiconductor substrate comprising a step of encircling a ZnO substrate having crystal orientation in the (000-1) plane or in the (0001) plane with a Zn -containing material and heating the substrate in this state at a temperature not lower than 800ºC.
